# EUROPÄISCHE PATENTANMELDUNG

(11) **EP 0 849 812 A2**
(43) Veröffentlichungstag der Anmeldung: **24.06.1998**
(21) Anmeldenummer: 97116796.0
(22) Anmeldetag: 26.09.1997
(51) Int. Cl.: H01L 33/00

(54) **LED mit allseitiger Lichtauskopplung**

(30) Priorität: 17.12.1996 DE 19652528
(71) Anmelder: SIEMENS AKTIENGESELLSCHAFT, 80333 München (DE)
(72) Erfinder: Hanke, Christian, Dr., 81737 München (DE); Stegmüller, Bernhard, Dr., 86163 Augsburg (DE)

(57) **Zusammenfassung**

Zur Verbesserung der Lichtauskopplung aus der LED wird bei der erfindungsgemäßen LED die laterale Auskopplung (Kantenemission) dadurch verbessert, daß mittels eines relativ dicken Wellenleiters die erzeugte Strahlung zu den Seitenflächen der LED hin geführt wird, und zwar so, daß möglichst viele Moden ausbreitungsfähig sind.

## Beschreibung

Es werden oberflächenemittierende und kantenemittierende LEDs verwendet. Bei den kantenemittierenden LEDs tritt das Licht seitlich in der Ebene der aktiven Zone aus. In der US 5,264,715 ist eine LED beschrieben, bei der das Licht in einem Wellenleiter zu den Seitenflächen des Bauelementes geführt wird. Es wird beschrieben, mit welchen Mitteln verhindert werden kann, daß das Licht sich in unerwünschten Moden in dem Wellenleiter ausbreitet. Bei einer angegebenen Ausführungsform ist die Dicke der Wellenleiterschicht auf etwas mehr als das 0,8-fache der Wellenlänge der erzeugten Strahlung bei Ausbreitung in dem Material der Wellenleiterschicht begrenzt. Der Wellenleiter wird bis an die Kante des Bauelementes geführt. Die aktive Zone kann ebenfalls bis zu den Kanten reichen oder auf einen Bereich im Innern der Wellenleiterschicht begrenzt sein.

Aufgabe der vorliegenden Erfindung ist es, eine LED-Struktur anzugeben, bei der die Lichtauskopplung gegenüber herkömmlichen LEDs deutlich verbessert ist.

Diese Aufgabe wird mit der LED mit den Merkmalen des Anspruches 1 gelöst. Weitere Ausgestaltungen ergeben sich aus den abhängigen Ansprüchen.

Zur Verbesserung der Lichtauskopplung aus der LED wird bei der erfindungsgemäßen LED die laterale Auskopplung (Kantenemission) dadurch verbessert, daß mittels eines relativ dicken Wellenleiters die erzeugte Strahlung zu den Seitenflächen der LED hin geführt wird, und zwar so, daß möglichst viele Moden ausbreitungsfähig sind.

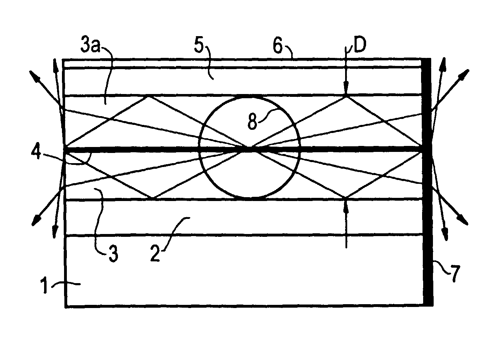

Die nachfolgende Beschreibung anhand der beigefügten Figur bezieht sich vorrangig auf eine LED-Struktur im Materialsystem von InGaAlAs, die eine sogenannte Heteroschichtstruktur auf einem Substrat, z. B. einem GaAs-Substrat, bildet. Die erfindungsgemäße Struktur ist entsprechend in einem anderen Materialsystem realisierbar, wie z. B. InGaAlP/GaAs, InGaAsP/InP oder InGaAsP/GaAs.

In der Figur ist eine Schichtfolge dargestellt, die auf einem Substrat 1 aufgewachsen ist. Es folgen aufeinander eine untere Mantelschicht 2, ein unterer Anteil 3 einer Wellenleiterschicht, eine für Strahlungserzeugung vorgesehene aktive Schicht 4, ein oberer Anteil 3a der Wellenleiterschicht, eine obere Mantelschicht 5 und eine Deckschicht 6. Die aktive Schicht wird als Schichtanteil der gesamten Wellenleiterschicht 3, 3a, 4 aufgefaßt. Die aktive Schicht ist wesentlich dünner als die Wellenleiterschicht. In dem hier vorrangig beschriebenen Materialsystem von GaAs ist das Substrat GaAs und jede der aufgewachsenen Schichten In_{y}Ga_{1-y}AlₓAs₁₋ₓ. Dabei variieren die x- und y-Werte so, daß der Brechungsindex der Mantelschichten deutlich niedriger ist als der Brechungsindex des angrenzenden Anteils der Wellenleiterschicht. Auf diese Weise wird eine Wellenführung im Innern der Wellenleiterschicht bewirkt. Die Materialeigenschaften der Materialsysteme sind bekannt. Z. B. erhöht sich der Brechungsindex mit abnehmendem Aluminiumanteil. Die aktive Zone 4 kann als einfache Potentialtopfstruktur (quantum well) oder als Mehrfachpotentialtopf (MQW, Multiple Quantum Well) ausgebildet sein. Die MQW-Struktur wird durch eine Schichtfolge aus Schichten unterschiedlichen Energiebandabstandes gebildet. Die einzelnen Schichten sind typisch 5 nm bis 20 nm dick. Die Wellenleiterschicht, innerhalb der die aktive Schicht angeordnet ist, ist aus einem Material höheren Energiebandabstandes (z. B. AlGaAs), das für das erzeugte Licht transparent ist. Kennzeichnend für diese Wellenleiterschicht 3, 3a, 4 ist eine Dicke D (Abmessung senkrecht zur Schichtebene) von mindestens einer, vorzugsweise von mehreren Wellenlängen der erzeugten Strahlung. Dabei ist zu berücksichtigen, daß die Wellenlänge der erzeugten Strahlung entsprechend der Größe des Brechungsindexes in dem Material kürzer ist als im Vakuum. Typische Abmessungen für die Dicke D der Wellenleiterschicht (gesamte Dicke der Schichten 3, 3a,4 senkrecht zur Schichtebene) liegen im Bereich von 0,5 µm bis 30 µm. Durch eine Dicke von mindestens 0,5 µm oder eine an das betreffende Material angepaßte Mindestdicke wird erreicht, daß bei einem durch die aneinander angrenzenden Materialien bedingten Sprung des Brechungsindexes an der Grenze zwischen der Wellenleiterschicht und den Mantelschichten mindestens zwei Moden der erzeugten Strahlung in dem Wellenleiter ausbreitungsfähig sind. Die Anzahl der ausbreitungsfähigen Moden, d. h. der Grundschwingungen der Strahlung innerhalb des Wellenleiters, hängt von dem Sprung des Brechungsindexes zwischen den Materialien des Wellenleiters und den angrenzenden Mantelschichten ab. Wesentlich für die erfindungsgemäße LED ist, daß mindestens zwei Moden der erzeugten Strahlung, vorzugsweise mehrere Moden, in dem Wellenleiter derart ausbreitungsfähig sind, daß die Strahlung die Kanten, d. h. die Seitenflächen, die die Wellenleiterschicht lateral in der Ebene der Schichten begrenzen, erreicht. Die Mantelschichten können aus Halbleitermaterial sein, sie können insbesondere durch Schichtfolgen (z. B. Schichten mit alternierendem Brechungsindex wie bei einem Bragg-Reflektor) gebildet sein, sie können aus einem Dielektrikum bestehen oder durch die umgebende Luft gebildet sein. Im letzteren Fall wird z. B. die obere Mantelschicht 5 weggelassen, und die Strominjektion in die aktive Schicht erfolgt durch den leitend dotierten oberen Anteil 3a der Wellenleiterschicht. Die in der Figur eingezeichneten Schichten 5 und 6 können also weggelassen sein.

Schichten beidseitig der aktiven Schicht 4 werden für elektrische Leitfähigkeit unterschiedlichen Vorzeichens dotiert. Es kann z. B. die Wellenleiterschicht 3, 3a wie die aktive Schicht undotiert bleiben, während die obere Mantelschicht 5 p-leitend und die untere Mantelschicht 2 n-leitend dotiert wird. Die Anschlußkontakte befinden sich dann z. B. auf der ebenfalls p-leitend dotierten Deckschicht 6 und auf der Unterseite des Substrates 1, das dann auch n-leitend dotiert ist. Für einen niedrigen Übergangswiderstand zwischen dem Metall des Kontaktes und dem Halbleitermaterial empfiehlt es sich, die Deckschicht 6 hoch zu dotieren. Falls die obere Mantelschicht 5 und die Deckschicht 6 weggelassen sind, wird der obere Anteil 3a der Wellenleiterschicht p-leitend dotiert. Der Kontakt wird dann direkt auf der oberen Wellenleiterschicht aufgebracht. Die Vorzeichen der Dotierung können auch umgekehrt sein.

In der Figur ist durch den Kreis 8 eine Zone angedeutet, in der bei angelegtem Strom als Folge der Strominjektion spontane Emission von Strahlung angeregt wird. Diese Strahlung wird in den eingezeichneten Pfeilrichtungen unter Mehrfachreflexion an den Grenzflächen der Wellenleiterschicht zu den Seitenflächen hin reflektiert. Die Abstrahlung erfolgt entsprechend den eingezeichneten Pfeilen seitlich in verschiedene Richtungen. Zur Verbesserung der Strahlungsauskopplung kann auf der Seitenfläche eine Antireflexschicht 7 vorgesehen sein, die in der Figur nur auf der rechten Seite angedeutet ist. Diese Antireflexschicht 7 kann weggelassen sein. Die Lichtauskopplung kann auch durch andere bekannte Maßnahmen verbessert werden. Die aktive Schicht 4 ist so ausgebildet, daß sie die Strahlung nicht oder nur sehr wenig absorbiert, so daß der gesamte Wellenleiter einschließlich der aktiven Schicht eine so geringe Absorption aufweist, daß praktisch alle im Innern des Wellenleiters total reflektierte Strahlung zu den Seitenflächen geführt wird. Bei der erfindungsgemäßen LED-Struktur ist daher die Strahlungsauskopplung an den Seitenflächen besonders hoch.

Die aktive Schicht 4 kann wie in der Figur gezeichnet zwischen zwei gleich dicken Anteilen 3, 3a der Wellenleiterschicht angeordnet sein. Besonders gute Funktion der erfindungsgemäßen Diode ergibt sich bei asymmetrischer Anordnung der aktiven Schicht innerhalb des Wellenleiters, wobei ein Anteil (3 oder 3a) der Wellenleiterschicht höchstens halb so dick, vorzugsweise höchstens ein zehntel so dick ist wie der andere (3a bzw. 3). Bei einem typischen Ausführungsbeispiel kann die Dicke D der gesamten Wellenleiterschicht etwa 6 µm sein; die aktive Schicht 4 ist im Abstand von 100 nm von einer Mantelschicht 2, 5 angeordnet. Dieser Abstand der aktiven Schicht von einer Mantelschicht kann beliebig klein gewählt werden. Der untere Anteil 3 oder der obere Anteil 3a der Wellenleiterschicht unter bzw. über der aktiven Schicht kann ganz entfallen.

## Patentansprüche

1. Lichtemittierende Diode mit einer Schichtfolge aus Halbleitermaterial
- mit einer für Strahlungserzeugung vorgesehenen aktiven Schicht (4),
- mit einer Wellenleiterschicht (3, 3a, 4), die für in der aktiven Schicht erzeugte Strahlung durchlässig ist,
- mit mindestens einer Mantelschicht (2) aus einem Material, das einen niedrigeren Brechungsindex hat als das Material der Wellenleiterschicht, und
- mit Kontakten für Strominjektion,
- bei der die aktive Schicht einen Schichtanteil der Wellenleiterschicht bildet,
- bei der die Dicke der Wellenleiterschicht mindestens gleich ist der Wellenlänge der in der aktiven Schicht erzeugten Strahlung bei Ausbreitung in dem Material der Wellenleiterschicht,
- bei der die aktive Schicht in der Wellenleiterschicht asymmetrisch angeordnet ist,
- bei der die Seitenflächen, die die Wellenleiterschicht in ihren seitlichen Abmessungen in der Schichtebene begrenzen, für Lichtaustritt vorgesehen sind und
- bei der die Kontakte jeweils mit einem über bzw. unter der aktiven Schicht angeordneten und für jeweils einen Typ elektrischer Leitfähigkeit dotierten Bereich elektrisch leitend verbunden sind.

2. LED nach Anspruch 1,
bei der die Wellenleiterschicht mindestens 0,5 µm dick ist.

3. LED nach Anspruch 1 oder 2,
bei der die aktive Schicht zwischen zwei Anteilen (3, 3a) der Wellenleiterschicht angeordnet ist, von denen der eine Anteil höchstens halb so dick ist wie der andere.

4. LED nach Anspruch 1 oder 2,
bei der die aktive Schicht zwischen zwei Anteilen (3, 3a) der Wellenleiterschicht angeordnet ist, von denen der eine Anteil höchstens ein zehntel so dick ist wie der andere.

5. LED nach Anspruch 1 oder 2,
bei der die Wellenleiterschicht durch die aktive Schicht und einen restlichen Anteil gebildet wird und bei der die aktive Schicht über oder unter diesem restlichen Anteil angeordnet ist.

6. LED nach einem der Ansprüche 1 bis 5,
bei der die aktive Schicht als MQW-Schichtfolge ausgebildet ist.
